# EUROPEAN PATENT APPLICATION

(11) **EP 3 196 617 A1**
(43) Date of publication of application: **26.07.2017**
(21) Application number: 17150950.8
(22) Date of filing: 11.01.2017
(51) Int. Cl.: G01L 9/00, G01L 19/06

(54) **MEMS PRESSURE SENSOR WITH MODIFIED CAVITY TO IMPROVE BURST PRESSURE**

(30) Priority: 19.01.2016 US 201615001067
(71) Applicant: Rosemount Aerospace Inc., Burnsville MN 55306-4898 (US)
(72) Inventor: ZHANG, Weibin, Burnsville, MN Minnesota 55337 (US); POTASEK, David P., Lakeville, MN Minnesota 55044 (US)
(74) Representative: Iceton, Greg James

(57) **Abstract**

A method for producing a silicon based MEMS pressure sensor includes forming a cavity in a first (100) surface of a silicon wafer with first and second parallel (100) surfaces wherein the angle between the walls of the first cavity and the first (100) surface where they intersect the first (100) surface are greater than 90 degrees and the remaining material between the bottom of the cavity and the second parallel (100) surface comprises a flexible diaphragm. The method also includes forming a backing wafer, having a through hole, and bonding the silicon wafer to the backing wafer such that the hole in the backing wafer matches up with the cavity in the second side of the (100) silicon wafer. A dielectric layer is formed on the second side of the (100) silicon wafer and a sensing element is formed on the dielectric layer to detect pressure induced deflection of the silicon diaphragm.

## Description

### BACKGROUND

The present invention relates generally to pressure sensors for use in industrial process control and monitoring applications. In particular, the present invention relates to solid state pressure sensors with robust MEMS sensing elements.

Pressure transmitters and other pressure sensing devices include a pressure sensor that senses the pressure of a process fluid. The pressure sensor responds to a pressure or changing pressure by providing an electrical signal characteristic of the pressure that is detected by appropriate sensing circuitry.

MEMS pressure sensing elements are in common use in industry and, in many cases, are limited in some applications by their burst pressures.

### SUMMARY

A method for producing a silicon based MEMS pressure sensor includes forming a cavity in a first (100) surface of a silicon wafer with first and second parallel (100) surfaces wherein the angle between the walls of the first cavity and the first (100) surface where they intersect the first (100) surface are greater than 90 degrees and the remaining material between the bottom of the cavity and the second parallel (100) surface comprises a flexible diaphragm. The method also includes forming a backing wafer having a through hole, and bonding the silicon wafer to the backing wafer such that the hole in the backing wafer matches up with the cavity in the second side of the (100) silicon wafer. A dielectric layer is formed on the second side of the (100) silicon wafer and a sensing element is formed on the dielectric layer to detect pressure induced deflection of the silicon diaphragm.

In an embodiment a silicon based MEMS pressure sensor includes a silicon wafer with first and second parallel (100) surfaces and a cavity in the first (100) surface wherein the bottom of the cavity is proximate the second (100) surface thereby forming a flexible diaphragm in the wafer at the bottom of the cavity. The angle between the walls of the cavity and the first (100) surface where the cavity intersects the first (100) surface is greater than 90 degrees. A backing wafer containing a through hole is bonded to the first (100) surface of the silicon wafer such that the through hole and the cavity are connected. The sensor further includes a dielectric layer on the second (100) surface of the silicon wafer and a sensing element on the dielectric layer to detect pressure induced deflection of the diaphragm.

### BRIEF DESCRIPTION OF THE DRAWINGS

FIG. 1 is a diagram of a prior art MEMS pressure transducer.
FIG. 2 is a diagram of a MEMS pressure transducer according to an embodiment of the invention.
FIG. 3 is a diagram of a MEMS pressure transducer according to another embodiment of the invention.
FIG. 4 is a flow chart of a process of forming the MEMS cavity shape according to an embodiment of the invention.
FIG. 5 is a diagram showing the development of the MEMS cavity shape according to an embodiment of the invention.
FIG. 6 is a micrograph of a MEMS cavity according to an embodiment of the invention.

### DETAILED DESCRIPTION

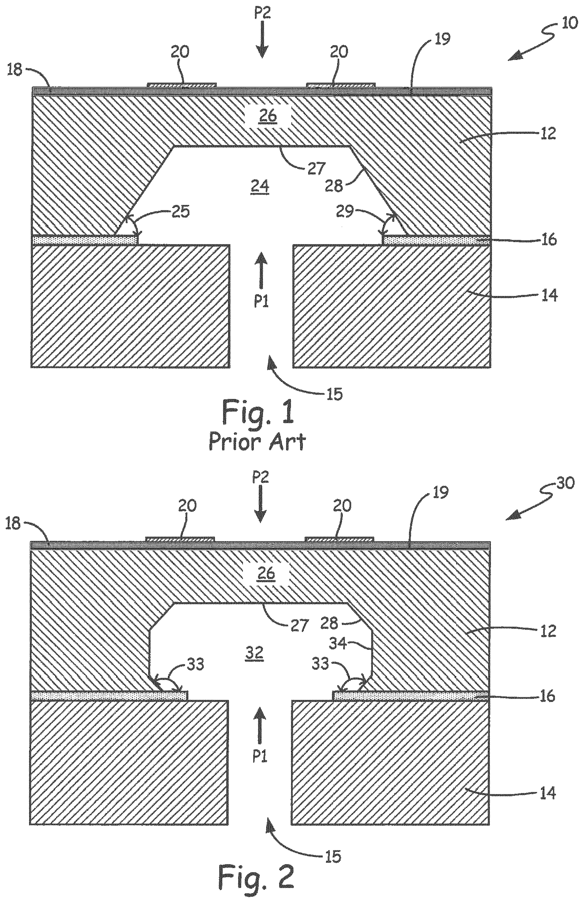

The present disclosure describes a silicon based MEMS pressure sensor with improved burst pressure. FIG. 1 is a diagram showing a cross-section of a prior art silicon based MEMS sensor 10 for detecting pressure. Sensor 10 may comprise cube oriented single crystal silicon layer 12 on backing wafer 14 wherein a (100) plane (according to the Miller indices notation of crystals) is approximately parallel to the top surface of layer 12. Silicon layer 12 may be bonded to backing wafer 14 by bond layer 16. Dielectric layer 18 may be on top surface 19 of silicon layer 12 and sensing elements 20 may be on dielectric layer 18. Cavity 24 with surface 27 may form a thin portion of silicon layer 12 that forms flexible membrane 26 that allows sensor 10 to detect pressure difference between P1 and P2 via sensing elements 20. In the embodiment shown in FIG. 1, MEMS sensor 10 is in a configuration for a differential pressure sensor wherein sensor 10 responds to the difference in pressures P1 and P2 simultaneously acting on sensor 10. Sensing elements 20 may be piezoelectric, piezoresistive or other sensing elements known in the art.

Cavity 24 may be formed in single crystal silicon layer 12 by a wet etching process using potassium hydroxide (KOH) and/or tetramethyl ammonium hydroxide (TMAH) etchants. Silicon layer 12 may have an orientation wherein top surface 19 is a cube plane. During etching of cavity 24, facet 27 and facet 28 may be preferentially etched producing the trapezium cross-section shown on the figure. In an exemplary embodiment, facet 27 may be a (100) cube plane and facet 28 may be a (111) plane and angles 29 may be about 54.7 degrees. This trapezium transducer structure is commonly known in the art. Pressure sensor 10 may be an absolute pressure sensor responding to one of pressure P1 and P2 while the other pressure of pressure P1 and P2 is a fixed pressure. Pressure sensor 10 may also be a differential pressure sensor responding to pressures P1 and P2 wherein the sensor output would be the difference between pressure P1 and P2.

Since angles 29 are less than 90 degrees, a higher internal pressure P1 (P1>P2) results in a tensile stress concentration acting at the base of both angles 29 leading to a burst pressure limit that is less than ideal. The present disclosure teaches a method and sensor configuration that may eliminate the stress concentration and may result in a lower burst pressure limit.

FIG. 2 is a diagram showing a cross-section of MEMS sensor 30 according to an embodiment of the present invention. Octagonal cavity 32, shown in FIG. 2, may be formed in sensor 30 by a combination of both wet KOH/TMAH etching and dry deep reactive ion etching (DRIE), wherein identical numbers used previously in FIG. 1 refer to the same features. In sensor 30, angles 33 between the walls of wet etched cavity 32 and backing layer 14 at bond line 16 are greater than 90 degrees, resulting in the elimination of pressure induced tensile stress concentrations at those points. As discussed below, angles 33 may be about 125.3 degrees in some embodiments. The production of angles 33 that are greater than 90 degrees forms the basis of the present invention. It is apparent that any pressure P1 in cavity 32 will not result in a stress concentration at the intersection of the walls of cavity 32 and bond line 16/backing layer 14. The result is an increased burst pressure of sensor 30.

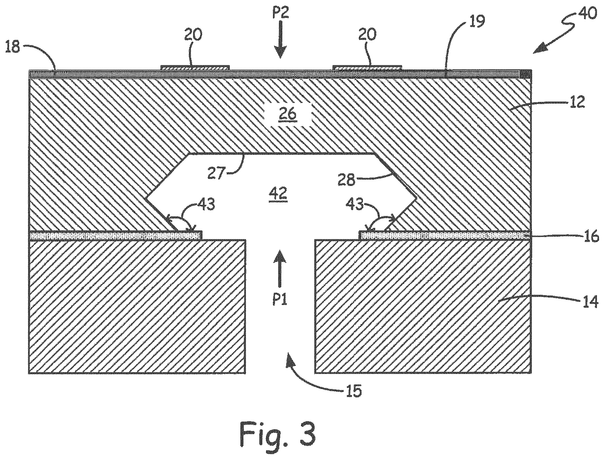

In another embodiment of the invention, shown in FIG. 3, hexagonal cavity 42 in sensor 40 may be formed by a combination of both wet KOH/TMAH etching and dry deep reactive ion etching (DRIE) etching, where identical numbers used previously in FIG. 1 refer to the same features. In sensor 40, angles 43 between the walls of wet etched cavity 42 and backing layer 14 at bond line 16 are greater than 90 degrees, resulting in the elimination of pressure induced tensile stress concentration at those points. As discussed below, angles 43 may be about 125.3 degrees in some embodiments. The production of angles 33 and 43 that are greater than 90 degrees forms the basis of the present invention. It is apparent that any pressure P1 on cavity 42 will not result in a stress concentration at the intersection of the walls of cavity 42 and bond line 16/backing layer 14. The result is an increased burst pressure of sensor 40.

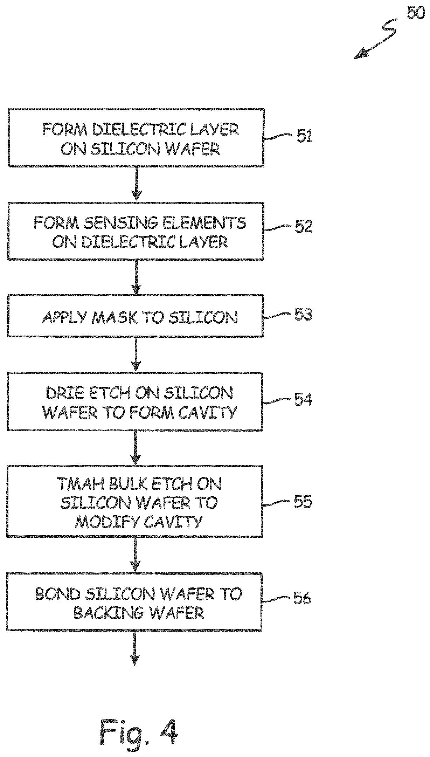

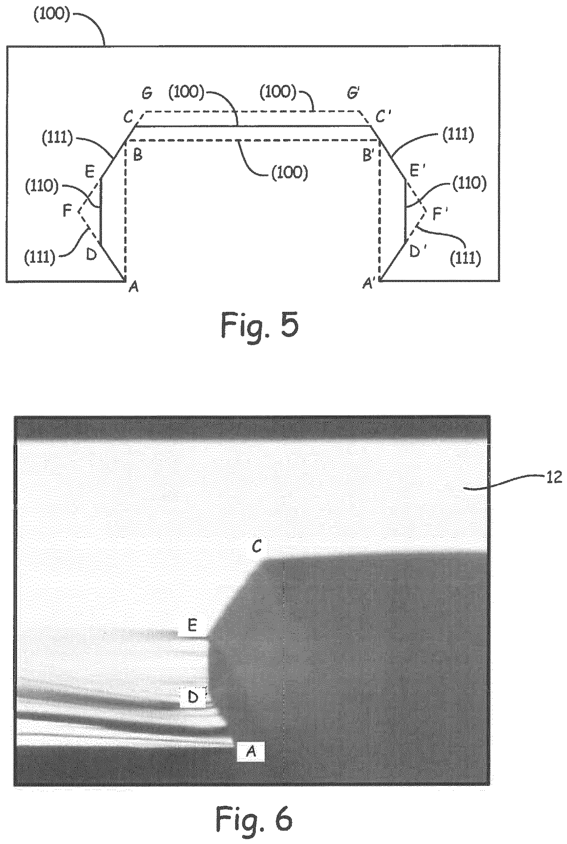

FIG. 4 is a flow diagram of a process of forming the sensor configurations described here in FIG. 2. In the first step, dielectric layer 18 is formed on silicon wafer 12 (step 51). In some embodiments, the dielectric layer is silicon oxide. In the next step sensing elements 20 are formed on dielectric layer 18 (step 52). Sensing elements 20 may be piezoresistive, piezoelectric, or others known in the art. In the next step, a mask outlining a cavity is applied to (100) silicon wafer 12 (step 53). In the next step, masked wafer 12 is subjected to a deep reactive ion etch (DRIE) (step 54). A diagram showing the evolution of the sensor cavity configuration is shown in FIG. 5. The DRIE etch forms the rectangular cavity ABB'A' in the starting (100) wafer. A fluorine based DRIE etch may be used for silicon. In the next step, the initial cavity is subjected to a wet etch to modify the cavity's shape (step 55). During wet etching, the (100), (110), and (111) planes are preferentially dissolved. Etching rates are highest on (110) and (100) planes respectively. Etch rates on (111) planes are orders of magnitude lower. As a result, as shown in FIG. 5, the (111) planes are etch stops and the size of the cavity is primarily related to the size of the DRIE etched starting cavity. As etching proceeds, octagonal cavity ADECC'E'D'A' develops as demonstrated in sensor 30 shown in FIG. 2. If etching is continued, the hexagonal cavity AFGG'F'A' develops as demonstrated in sensor 40 shown in FIG. 3. Wet etching agents for the silicon sensors of the invention may be KOH and/or TMAH at temperatures between room temperature and about 100°C.

Following cavity formation, silicon wafer 12 is bonded to backing wafer 14 (step 54). The bonding may include frit, silicon-silicon direct fusion bonding, silicon to Pyrex anodic bonding and metal eutectic bonding.

A photomicrograph of a cross-section of an exemplary octagonal shape cavity is shown in FIG. 6 with features marked as in FIG. 5.

### Discussion of Possible Embodiments

The following are nonexclusive descriptions of possible embodiments of the present invention.

A method for producing a silicon based MEMS pressure sensor includes: forming a cavity in a first (100) surface of a silicon wafer with first and second parallel (100) surfaces wherein angles between the walls of the cavity intersecting the first (100) surface and the first (100) surface are greater than 90 degrees, and remaining material between the bottom of the cavity and the second (100) surface defines a flexible diaphragm; forming a backing wafer having a through hole; bonding the silicon wafer to the backing wafer such that the hole in the backing wafer matches up with the cavity in the first (100) surface of the silicon wafer; forming at least one dielectric layer on the second side of the (100) silicon wafer; and forming a sensing element on the dielectric layer to detect pressure induced deflection of the flexible diaphragm.

The method of the preceding paragraph can optionally include, additionally and/or alternatively any, one or more of the following features, configurations and/or additional components: the cavity in the first (100) surface may be formed by a two-step etching process consisting of forming a cavity with vertical walls by ion etching followed by shaping the cavity by wet etching, wherein the angle between the cavity walls and the first (100) surface of the wafer is greater than 90 degrees.

The cavity may have an octagonal or hexagonal cross-section.

Ion etching may be deep reactive ion etching (DRIE).

Wet etching may be etching using KOH or TMAH etching reagents.

The backing wafer may be silicon, ceramic, or Pyrex glass.

The hole in the backing wafer may be formed by deep reactive ion etching (DRIE).

The angle between the cavity walls and the first (100) side of the wafer may be about 125.3 degrees.

The dielectric layer may be silicon oxide.

Bonding may include frit bonding, silicon-silicon direct fusion bonding, silicon to Pyrex anodic bonding, and metal anodic bonding.

A silicon based MEMS pressure sensor may include: a silicon wafer with first and second parallel (100) surfaces; a cavity in the first (100) surface, where a bottom of the cavity is proximate the second (100) surface thereby forming a flexible diaphragm in the wafer, where angles between the walls of the cavity and the first (100) surface where the cavity intersects the first surface may be greater than 90 degrees; a backing wafer containing a through hole bonded to the first (100) surface of the silicon wafer such that the through hole and the cavity are connected; at least one dielectric layer on second (100) surface of the silicon wafer; and a sensing element on the dielectric layer to detect pressure induced deflection of the flexible diaphragm.

The pressure sensor of preceding paragraph can optionally include, additionally and/or alternatively any, one or more of the following features, configurations, and/or additional components:

The cross-section of the cavity may have hexagonal or octagonal walls.

The angle between the cavity walls at the point where the cavity intersects the first silicon (100) surface maybe about 125.3 degrees.

The backing wafer may be silicon, ceramic, or Pyrex glass.

The backing wafer may be bonded to the first (100) silicon wafer surface using frit bonding, silicon-silicon direct fusion bonding, silicon to Pyrex anodic bonding, and metal anodic bonding.

The dielectric layer may be silicon oxide.

The sensing element may be piezo resistive or piezo electric.

The cavity may be formed by ion etching followed by wet etching.

The ion etching may be deep reactive ion etching (DRIE) and the wet etching is TMAH etching.

The hole in the backing wafer may be formed by DRIE.

While the invention has been described with reference to an exemplary embodiment(s), it will be understood by those skilled in the art that various changes may be made without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A method for producing a silicon based MEMS pressure sensor comprising:
forming a cavity in a first (100) surface of a silicon wafer with first and second parallel (100) surfaces wherein angles between the walls of the cavity intersecting the first (100) surface and the first (100) surface are greater than 90 degrees, and remaining material between the bottom of the cavity and the second (100) surface defines a flexible diaphragm;
forming a backing wafer having a through hole;
bonding the silicon wafer to the backing wafer such that the hole in the backing wafer matches up with the cavity in the first (100) surface of the silicon wafer;
forming at least one dielectric layer on the second side of the (100) silicon wafer; and
forming a sensing element on the dielectric layer to detect pressure induced deflection of the flexible diaphragm.

2. The MEMS sensor of claim 1, wherein the cavity in the first (100) surface is formed by a two-step etching process comprising forming a cavity with vertical walls by ion etching followed by shaping the cavity by wet etching, wherein the angle between the cavity walls and the first (100) surface of the wafer is greater than 90 degrees, and preferably 125.3 degrees

3. The MEMS sensor of claim 2, wherein the cavity has an octagonal or hexagonal cross-section.

4. The MEMS sensor of claim 2, wherein ion etching comprises deep reactive ion etching (DRIE); and wherein wet etching comprises etching using KOH or TMAH etching reagents.

5. The MEMS sensor of claim 1, wherein the backing wafer is silicon, ceramic, or Pyrex glass.

6. The MEMS sensor of claim 1, wherein the hole in the backing wafer is formed by deep reactive ion etching (DRIE).

7. The MEMS sensor of claim 1, wherein the dielectric layer is silicon oxide.

8. The MEMS sensor of claim 1, wherein bonding comprises frit bonding, silicon-silicon direct fusion bonding, silicon to Pyrex anodic bonding, and metal anodic bonding.

9. A silicon based MEMS pressure sensor comprising:
a silicon wafer with first and second parallel (100) surfaces;
a cavity in the first (100) surface, wherein a bottom of the cavity is proximate the second (100) surface thereby forming a flexible diaphragm in the wafer, wherein angles between the walls of the cavity and the first (100) surface where the cavity intersects the first surface are greater than 90 degrees and preferably 125.3 degrees;
a backing wafer containing a through hole bonded to the first (100) surface of the silicon wafer such that the through hole and the cavity are connected;
at least one dielectric layer on second (100) surface of the silicon wafer; and
a sensing element on the dielectric layer to detect pressure induced deflection of the flexible diaphragm.

10. The MEMS pressure sensor of claim 9, wherein the cross-section of the cavity forms hexagonal or octagonal walls.

11. The MEMS pressure sensor of claim 9, wherein the backing wafer is silicon, ceramic, or Pyrex glass, and preferably wherein the backing wafer is bonded to the first (100) silicon wafer surface using frit bonding, silicon-silicon direct fusion bonding, silicon to Pyrex anodic bonding, and metal anodic bonding.

12. The MEMS pressure sensor of claim 9, wherein the dielectric layer is silicon oxide.

13. The MEMS pressure sensor of claim 9, wherein the sensing element is piezo resistive or piezo electric.

14. The MEMS pressure sensor of claim 9, wherein the cavity is formed by ion etching followed by wet etching, wherein the ion etching is deep reactive ion etching (DRIE) and the wet etching is TMAH etching.

15. The MEMS pressure sensor of claim 9, wherein the hole in the backing wafer is formed by DRIE.
